# EUROPÄISCHE PATENTSCHRIFT

(11) **EP 2 847 444 B1**
(45) Veröffentlichungstag und Bekanntmachung des Hinweises auf die Patenterteilung: **11.07.2018**
(21) Anmeldenummer: 13722367.3
(22) Anmeldetag: 06.05.2013
(51) Int. Cl.: F01N 5/02, F01N 3/02, F28D 9/00, F28D 21/00

(54) **WÄRMETAUSCHER MIT THERMOELEKTRISCHEM GENERATOR**
HEAT EXCHANGER HAVING A THERMOELECTRIC GENERATOR
ÉCHANGEUR DE CHALEUR COMPRENANT UN GÉNÉRATEUR THERMOÉLECTRIQUE

(30) Priorität: 08.05.2012 DE 102012207612
(43) Veröffentlichungstag der Anmeldung: 18.03.2015
(73) Patentinhaber: Eberspächer Exhaust Technology GmbH & Co. KG, 66539 Neunkirchen (DE)
(72) Erfinder: RESCH, Andreas, 73732 Esslingen (DE)
(74) Vertreter: BRP Renaud & Partner mbB Rechtsanwälte Patentanwälte Steuerberater
(86) Internationale Anmeldenummer: PCT/EP2013/059392
(87) Internationale Veröffentlichungsnummer: WO 2013/167535

(56) Entgegenhaltungen:
- WO-A2-2010/106156
- WO-A2-2011/095255
- DE-A1-102010 030 259

## Beschreibung

Die vorliegende Erfindung betrifft einen Wärmetauscher, insbesondere für eine Abgasanlage einer Brennkraftmaschine, vorzugsweise in einem Kraftfahrzeug. Die vorliegende Erfindung betrifft außerdem eine mit einem derartigen Wärmetauscher ausgestattete Brennkraftmaschine.

Um bei Brennkraftmaschinen, insbesondere bei Fahrzeuganwendungen, den energetischen Wirkungsgrad zu verbessern, bestehen Bestrebungen, Wärmeenergie, die im Abgas der Brennkraftmaschine enthalten ist, zu nutzen. Eine Möglichkeit zur Nutzung der im Abgas enthaltenen Wärmeenergie ist dabei die Verwendung sogenannter thermoelektrischer Generatoren, die eine Temperaturdifferenz in eine elektrische Spannung bzw. einen Wärmestrom in einen elektrischen Strom wandeln können. Derartige thermoelektrische Generatoren arbeiten dabei nach dem sogenannten Seebeck-Effekt, der einer Invertierung des sogenannten Peltier-Effekts entspricht.

Ein thermoelektrischer Generator besteht üblicherweise aus mehreren einzelnen thermoelektrischen Elementen, die auch als thermoelektrische Module bezeichnet werden können und die jeweils eine Heißseite und eine Kaltseite besitzen. Durch Zuführen von Wärme zur Heißseite und durch Abführen von Wärme an der Kaltseite kann ein Wärmestrom durch das jeweilige thermoelektrische Element hindurchgeführt werden, der im thermoelektrischen Element in einen elektrischen Strom gewandelt wird. Um die Heißseite mit Wärme und die Kaltseite mit Kälte versorgen zu können, kann ein thermoelektrischer Generator zweckmäßig in einen Wärmetauscher integriert sein, der zumindest einen Heizkanal zum Führen eines Heizmittels und wenigstens einen Kühlkanal zum Führen eines Kühlmittels aufweist. Der thermoelektrische Generator ist dann zwischen einem solchen Heizkanal und einem solchen Kühlkanal so angeordnet, dass sich der Heizkanal an der Heißseite des jeweiligen thermoelektrischen Generators und der Kühlkanal an der Kaltseite des jeweiligen thermoelektrischen Generators befinden. Zu diesem Zweck sind der Heizkanal, der thermoelektrische Generator und der Kühlkanal in einer Stapelrichtung aufeinander gestapelt und bilden so einen Kanalstapel.

Ein derartiges thermoelektrisches Element bzw. ein derartiges thermoelektrisches Modul besteht aus einer Vielzahl von Halbleiterelementen, die einen Wärmestrom in einen Elektrodenstrom wandeln und umgekehrt. Im jeweiligen thermoelektrischen Element sind üblicherweise mehrere derartige Halbleiterelemente in Reihe geschaltet. Insbesondere sind positiv dotierte Halbleiterelemente, kurz p-Leiter, und negativ dotierte Halbleiterelemente, kurz n-Leiter, einander abwechselnd in Reihe geschaltet. Die elektrische Verbindung aufeinanderfolgender p-Leiter und n-Leiter erfolgt üblicherweise mittels Brückenelementen, die bevorzugt aus einem Metall bestehen. Zusammengefast bedeutet dies, dass das jeweilige thermoelektrische Element eine Vielzahl von thermoelektrisch wirkenden Halbleiterelementen aufweist.

Bei bestimmten Halbleitermaterialien, die innerhalb des jeweiligen thermoelektrischen Elements die thermoelektrische Wandlung bewirken, kann es erforderlich sein, diese vor einem Kontakt mit Sauerstoff zu schützen. Hierzu ist es bei herkömmlichen thermoelektrischen Generatoren üblich, jedes einzelne thermoelektrische Element für sich hermetisch zu kapseln. Diese Kapselung erfolgt dabei mit einer Art Gehäuse oder Hülle, die das jeweilige thermoelektrische Element vollständig einschließt und umhüllt. Je nach Werkstoff dieses Gehäuses bzw. dieser Hülle ergibt sich an dieser Stelle ein zusätzlicher thermischer Widerstand, der die Effizienz des thermoelektrischen Generators reduziert. Ein thermoelektrischer Generator, der mehrere thermoelektrische Elemente aufweist, umfasst somit mehrere jeweils für sich, also separat gekapselte thermoelektrische Elemente, die in ihrer Kapselung jeweils mehrere thermoelektrische Halbleiterlemente aufweisen. Ein solches System ist z.B. in dem Dokument WO 2011/095255 offenbart.

Die vorliegende Erfindung beschäftigt sich mit dem Problem, für einen Wärmetauscher der eingangs genannten Art eine verbesserte Ausführungsform anzugeben, die sich insbesondere durch einen vereinfachten Aufbau auszeichnet. Ferner ist angestrebt, für einen derartigen Wärmetauscher einen erhöhten energetischen Wirkungsgrad bei der Umwandlung von Wärme in Elektrizität zu erzielen. Dieses Problem wird erfindungsgemäß durch den Gegenstand des unabhängigen Anspruchs gelöst. Vorteilhafte Ausführungsformen sind Gegenstand der abhängigen Ansprüche.

Die Erfindung beruht auf dem allgemeinen Gedanken, den Wärmetauscher mit einem Gehäuse auszustatten, das einen Innenraum des Gehäuses umhüllt und in dem zumindest ein doppelwandiger Zwischenboden angeordnet ist, der einerseits zur Unterbringung der thermoelektrischen Elemente des jeweiligen thermoelektrischen Generators dient und zum anderen unmittelbar einen Kühlkanal von einem Heizkanal fluidisch trennt. Der doppelwandige Zwischenboden besitzt somit eine Doppelfunktion, da er nach innen mit seinen beiden Wänden einen Aufnahmeraum für den jeweiligen thermoelektrischen Generator bildet und nach außen mit seinen beiden Wänden einerseits einen Kühlkanal und andererseits einen Heizkanal begrenzt. Auf diese Weise kann der jeweilige thermoelektrische Generator im Zwischenboden in Verbindung mit dem Gehäuse, in welches der Zwischenboden eingesetzt ist, insgesamt gekapselt werden, wodurch das Innere des Zwischenbodens nach außen hermetisch abgedichtet werden kann. Beispielsweise kann der Zwischenboden als Flachrohr konzipiert sein, das an seinen Längsenden durch das Gehäuse des Wärmetauschers verschlossen ist. Ebenso ist es möglich, die beiden Wände des Zwischenbodens als separate Platten zu konzipieren, die entlang ihres Umfangsrands vom Gehäuse des Wärmetauschers dicht eingefasst sind.

Mit anderen Worten, die Erfindung schlägt vor, im Gehäuse mit Hilfe wenigstens eines solchen doppelwandigen Zwischenbodens einerseits den jeweiligen Heizkanal vom jeweiligen Kühlkanal zu trennen und andererseits den jeweiligen thermoelektrischen Generator einerseits vom jeweiligen Kühlkanal und andererseits vom jeweiligen Heizkanal zu trennen. Im Vergleich zu einer herkömmlichen Bauform, die den jeweiligen Heizkanal und den jeweiligen Kühlkanal mit Hilfe von Rohren realisiert, zwischen denen dann der jeweilige thermoelektrische Generator angeordnet werden kann, benötigt der erfindungsgemäße Wärmetauscher anstelle eines Heizrohrs und eines Kühlrohrs nur einen Zwischenboden, wodurch deutlich weniger Bauteile verwendet werden müssen, um den Wärmetauscher zu realisieren. Möglich ist dies dabei durch den jeweiligen doppelwandigen Zwischenboden in Verbindung mit dem Gehäuse, das den Innenraum des Wärmetauschers allseitig umhüllt.

Beispielsweise kann, insbesondere bei einer Fahrzeuganwendung, als Kühlmittel das Kühlmittel eines Kühlkreises einer Brennkraftmaschine verwendet werden, während als Heizmittel das Abgas der Brennkraftmaschine verwendet werden kann.

Der doppelwandige Zwischenboden kann dabei mit Hilfe von zwei separaten Wänden realisiert werden, die in das Gehäuse des Wärmetauschers eingesetzt sind. Die thermoelektrischen Elemente des jeweiligen thermoelektrischen Generators werden dabei zwischen den beiden Wänden angeordnet. Alternativ ist es gemäß einer bevorzugten Ausführungsform möglich, den jeweiligen doppelwandigen Zwischenboden mit Hilfe eines Flachrohrs zu realisieren, in das die thermoelektrischen Elemente des thermoelektrischen Generators eingesetzt sind und das in das Gehäuse des Wärmetauschers eingebaut ist.

Bei einer anderen vorteilhaften Ausführungsform kann der jeweilige Zwischenboden eine Heißwand, eine Kühlwand und einen zwischen Heißwand und Kühlwand ausgebildeten Zwischenraum aufweisen, wobei im eingebauten Zustand die jeweilige Heißwand einen solchen Heizkanal begrenzt, derart, dass sie den Zwischenraum vom Heizmittel dieses Heizkanals trennt. Ferner begrenzt die jeweilige Kühlwand einen solchen Kühlkanal, derart, dass sie den Zwischenraum vom Kühlmittel dieses Kühlkanals trennt. Des Weiteren können im jeweiligen Zwischenraum die thermoelektrischen Elemente des jeweiligen thermoelektrischen Generators angeordnet sein, derart, dass die Heißseiten der thermoelektrischen Elemente direkt oder indirekt an der Heizwand anliegen und die Kaltseiten der thermoelektrischen Elemente direkt oder indirekt an der Kühlwand anliegen. Sofern die jeweilige Wand und die jeweilige Seite hinreichend plan gefertigt werden können, ist eine direkte Kontaktierung zwischen der jeweiligen Seite und der jeweiligen Wand bevorzugt. Häufig lassen sich jedoch Herstellungstoleranzen nicht so eng wählen, dass eine hinreichende flächige Kontaktierung zwischen der jeweiligen Seite und der jeweiligen Wand gewährleistet werden kann. In diesem Fall ist dann eine indirekte Kontaktierung über ein Wärmeleitmaterial bevorzugt, das, beispielsweise in Form einer Folie oder einer Paste, zwischen der jeweiligen Seite und der jeweiligen Wand angeordnet ist und sich durch eine Elastizität zum Ausgleichen von Unebenheiten sowie durch eine hohe Wärmeübertragungsleistung auszeichnet.

Unabhängig von der konkreten Realisierung des doppelwandigen Zwischenbodens ergibt sich durch die Verwendung eines derartigen doppelwandigen Zwischenbodens die Möglichkeit, den jeweiligen thermoelektrischen Generator insgesamt, also als Einheit hermetisch zu kapseln. Durch die Kapselung des thermoelektrischen Generators ist der gesamte thermoelektrische Generator ebenso wie die einzelnen thermoelektrischen Elemente vor einem Kontakt mit Sauerstoff geschützt. In der Folge ist es grundsätzlich möglich, die einzelnen thermoelektrischen Elemente im Zwischenboden ungekapselt unterzubringen. Hierdurch lässt sich sowohl an der Heißseite als auch an der Kaltseite jeweils eine Wand vermeiden, die zwangsläufig einen thermischen Widerstand besitzt. Somit kann insgesamt der energetische Wirkungsgrad des Wärmetauschers verbessert werden. Bei ungekapselten thermoelektrischen Elementen ist innerhalb des Zwischenbodens keine zusätzliche hermetische Kapselung der thermoelektrischen Halbleiter der wenigstens zwei thermoelektrischen Elemente vorgesehen, d.h. die Halbleiterlemente mehrerer thermoelektrischer Elemente befinden sich im gleichen Hohlraum, nämlich im Zwischenboden. Mit anderen Worten, ein Fluid, z.B ein Gas, vorzugsweise ein für die Halbleiterelemente inertes Gas oder Inertgas, oder aber ein Vakuum steht im Zwischenboden mit allen Halbleiterelementen der thermoelektrischen Elemente des jeweiligen thermoelektrischen Generators in Kontakt.

Dementsprechend kann gemäß einer besonders vorteilhaften Ausführungsform vorgesehen sein, dass die thermoelektrischen Elemente des jeweiligen thermoelektrischen Generators im jeweiligen Zwischenboden individuell ungekapselt sind, während sie durch den jeweiligen Zwischenboden als Gruppe insgesamt gekapselt sind. Zusätzlich oder alternativ kann vorgesehen sein, dass ein thermoelektrischer Körper des jeweiligen thermoelektrischen Elements, der aus einem thermoelektrischen Material, nämlich aus einer Vielzahl von thermoelektrischen Halbleitern besteht, an voneinander abgewandten Seiten, welche die Kaltseite und die Heißseite bilden, direkt oder indirekt an den Wänden des jeweiligen Zwischenbodens anliegt. Üblicherweise sind die flächig und vorzugsweise eben in Spalten und Zeilen angeordneten Halbleiterelemente an einer Oberweite und an einer Unterseite des thermoelektrischen Elements paarweise mittels elektrisch leitender Kontaktbrücken, insbesondere Metallbrücken, elektrisch miteinander Kontaktiert. Auf den Kontaktbrücken kann an der Oberseite und an der Unterseite jeweils ein, zweckmäßig plattenförmiger und insbesondere ebener, elektrischer Isolator angeordnet sein. Im ungekapselten Zustand bildet der jeweilige Isolator die Kaltseite bzw. die Heißseite des jeweiligen thermoelektrischen Elements.

Bei einer anderen vorteilhaften Ausführungsform können wenigstens zwei solche Heizkanäle über Heizmittel-Verbindungsrohre miteinander fluidisch verbunden sein, die sich durch einen Kühlkanal und durch zwei Zwischenböden hindurcherstrecken. Hierdurch lassen sich innerhalb des Kanalstapels mehrere Heizkanäle fluidisch miteinander verbinden, derart, dass mehrere Heizkanäle, vorzugsweise sämtliche Heizkanäle, über einen gemeinsamen Heizmitteleinlass und einen gemeinsamen Heizmittelauslass in einen Heizmittelpfad eingebunden werden können.

Zusätzlich oder alternativ kann vorgesehen sein, dass wenigstens zwei solche Kühlkanäle über Kühlmittel-Verbindungsrohre miteinander fluidisch verbunden sind, die sich durch einen Heizkanal und durch zwei Zwischenböden hindurcherstrecken. Auch diese Maßnahme führt dazu, dass mehrere Kühlkanäle innerhalb des Gehäuses fluidisch miteinander gekoppelt werden können, so dass am Gehäuse ein gemeinsamer Kühlmitteleinlass und ein gemeinsamer Kühlmittelauslass ausreichen, um wenigstens zwei Kühlkanäle, vorzugsweise sämtliche Kühlkanäle, in einen Kühlmittelpfad einzubinden.

Zweckmäßig können sich bei einer Weiterbildung die Heizmittel-Verbindungsrohre und/oder die Kühlmittel-Verbindungsrohre beabstandet zum Gehäuse im Inneren des Gehäuses erstrecken. Auf diese Weise sind die jeweiligen Verbindungsrohre vom Heizmittel bzw. vom Kühlmittel umspült.

Bei einer alternativen Ausführungsform können im Kanalstapel bezüglich der Stapelrichtung der erste Kanal und der letzte Kanal vom gleichen Typ, also entweder vom Typ Heizkanal oder vom Typ Kühlkanal sein. In diesem Fall kann der Kanalstapel gemäß einer besonders vorteilhaften Ausführungsform im Gehäuse quer zur Stapelrichtung in einer Umfangsrichtung geschlossen von Verbindungskanälen eingefasst sein, welche den ersten Kanal und den letzten Kanal sowie jeden weiteren gegebenenfalls vorhandenen Kanal des gleichen Typs fluidisch miteinander verbinden. Auf diese Weise sind dann automatisch auch die Zwischenböden in dieser Umfangsrichtung von den Verbindungskanälen bzw. vom ersten und letzten Kanal eingefasst und somit innerhalb des darin geführten Fluids gekapselt. Die Umfangsrichtung, in der die Verbindungskanäle den Kanalstapel im Gehäuse einfassen, kann sich dabei auf die Stapelrichtung beziehen, so dass die Verbindungskanäle zwei stirnseitige Kanäle und zwei längsseitige Kanäle umfassen, die jeweils den ersten Kanal und den letzten Kanal miteinander verbinden. Alternativ dazu kann sich die Umfangsrichtung auch auf eine quer zur Stapelrichtung und quer zur Längsrichtung des Kanalstapels verlaufende Querrichtung beziehen. In diesem Fall bestehen die Verbindungskanäle nur aus den stirnseitigen Kanälen, welche den ersten Kanal mit dem letzten Kanal verbinden.

Besonders vorteilhaft ist dabei eine Weiterbildung, bei welcher der erste Kanal und der letzte Kanal Kühlkanäle sind. Somit befindet sich zwischen den thermoelektrischen Elementen und einer das Gehäuse umgebenden Umgebung eine Hülle aus Kühlmittel. Es hat sich gezeigt, dass eine hinreichende Abdichtung einer Flüssigkeit-(Kühlmittel) gegenüber einem Gas (Umgebungsluft) leichter realisierbar ist als eine Abdichtung eines ersten Gases (Abgas) gegenüber einem zweiten Gas (Umgebungsluft).

Der jeweilige Zwischenraum kann gemäß einer vorteilhaften Ausführungsform sowohl gegenüber dem Kühlmittel als auch gegenüber dem Heizmittel abgedichtet sein. Eine derartige Abdichtung vereinfacht sich insbesondere dann, wenn der Zwischenboden als Flachrohr konzipiert ist.

Bei einer anderen vorteilhaften Ausführungsform kann der jeweilige Zwischenraum mit einem Inertgas gefüllt sein oder ein Vakuum enthalten. In beiden Fällen ergibt sich ein besonders effizienter Schutz der thermoelektrischen Elemente vor einem Kontakt mit Sauerstoff.

Dementsprechend charakterisiert sich eine erfindungsgemäße Brennkraftmaschine, die insbesondere in einem Kraftfahrzeug angeordnet sein kann, durch einen Motorblock, der mehrere Brennräume enthält, durch eine Abgasanlage, die Abgas aus den Brennräumen abführt, durch einen Kühlkreis zum Kühlen des Motorblocks und durch einen Wärmetauscher der vorstehend beschriebenen Art, dessen Heizkanäle mit der Abgasanlage fluidisch gekoppelt sind und dessen Kühlkanäle mit dem Kühlkreis fluidisch gekoppelt sind.

Weitere wichtige Merkmale und Vorteile der Erfindung ergeben sich aus den Unteransprüchen, aus den Zeichnungen und aus der zugehörigen Figurenbeschreibung anhand der Zeichnungen.

Es versteht sich, dass die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Bevorzugte Ausführungsbeispiele der Erfindung sind in den Zeichnungen dargestellt und werden in der nachfolgenden Beschreibung näher erläutert, wobei sich gleiche Bezugszeichen auf gleiche oder ähnliche oder funktional gleiche Komponenten beziehen.

Es zeigen, jeweils schematisch,
- Fig. 1: eine stark vereinfachte, schaltplanartige Prinzipdarstellung einer Brennkraftmaschine,
- Fig. 2: einen stark vereinfachten Längsschnitt durch einen Wärmetauscher,
- Fig. 3: einen Längsschnitt durch einen Wärmetauscher wie in Fig. 2, jedoch bei einer anderen Ausführungsform,
- Fig. 4: ein vergrößertes Detail IV aus Fig. 3,
- Fig. 5: einen stark vereinfachten Längsschnitt durch ein einzelnes thermoelektrisches Element.

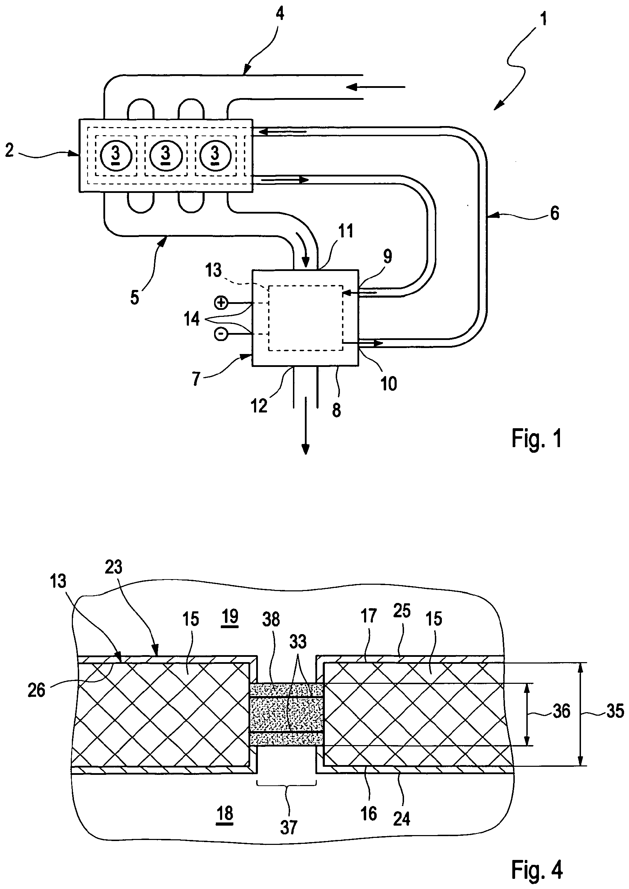

Entsprechend Fig. 1 umfasst eine Brennkraftmaschine 1, die bevorzugt in einem Kraftfahrzeug zum Einsatz kommen kann, einen Motorblock 2, der mehrere Brennräume 3 enthält, eine Frischluftanlage 4 zur Versorgung der Brennräume 3 mit Frischluft und eine Abgasanlage 5 zum Abführen von Abgas von den Brennräumen 3. Des Weiteren ist die Brennkraftmaschine 1 mit einem Kühlkreis 6 ausgestattet, mit dessen Hilfe der Motorblock 2 gekühlt werden kann. Dabei ist klar, dass im Kühlkreis 6 außerdem ein hier nicht gezeigter Kühler, gegebenenfalls in Verbindung mit einem Gebläse, vorgesehen sein kann, um das im Kühlkreis 6 geführte Kühlmittel entsprechend kühlen zu können.

Die Brennkraftmaschine 1 ist außerdem mit einem Wärmetauscher 7 ausgestattet, dessen Gehäuse 8 einen Kühlmitteleinlass 9, einen Kühlmittelauslass 10, einen Heizmitteleinlass 11 und einen Heizmittelauslass 12 aufweist. Der Wärmetauscher 7 ist über seinen Heizmitteleinlass 11 und seinen Heizmittelauslass 12 in die Abgasanlage 5 fluidisch eingebunden, wobei das Abgas im Wärmetauscher 7 als Heizmittel dient. Ferner ist der Wärmetauscher 7 über seinen Kühlmitteleinlass 9 und seinen Kühlmittelauslass 10 in den Kühlkreis 6 eingebunden, dessen Kühlmittel auch im Wärmetauscher 7 als Kühlmittel dient. Der Wärmetauscher 7 enthält außerdem zumindest einen thermoelektrischen Generator 13, der im Inneren des Wärmetauschers 7 mit dem Heizmittel und mit dem Kühlmittel wärmeübertragend gekoppelt ist. Am Gehäuse 8 sind elektrische Anschlüsse 14 ausgebildet, die mit dem jeweiligen thermoelektrischen Generator 13 entsprechend elektrisch verbunden sind.

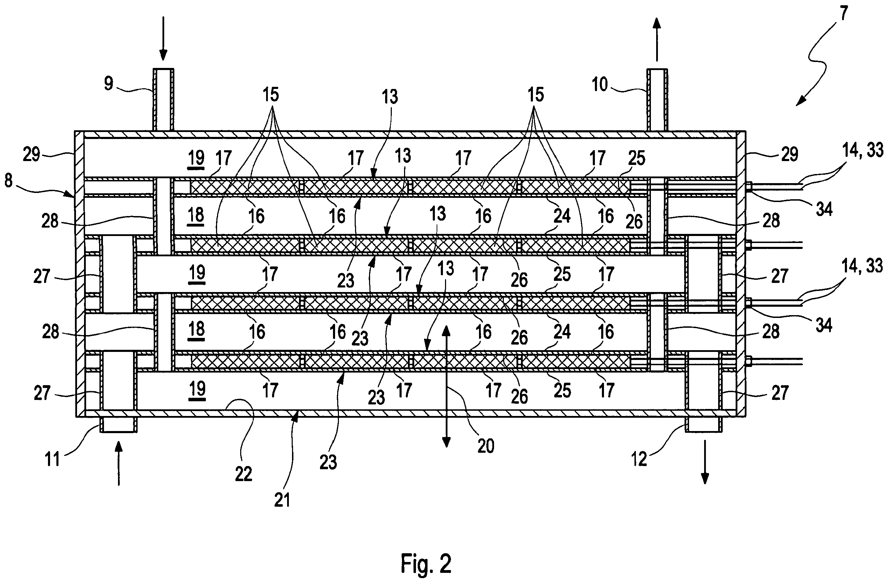

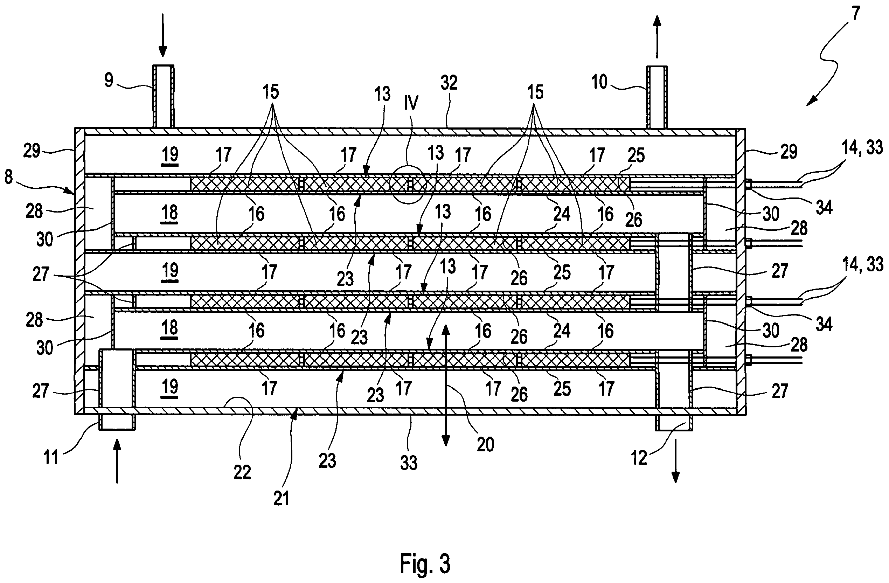

Entsprechend den Figuren 2 und 3 umfasst der jeweilige Wärmetauscher 7 vorzugsweise mehrere thermoelektrische Generatoren 13, die jeweils mehrere separate thermoelektrische Elemente 15 umfassen. Im Beispiel sind vier thermoelektrische Generatoren 13 vorgesehen, die jeweils vier thermoelektrische Elemente 15 besitzen. Jedes thermoelektrische Element 15 weist eine Heißseite 16 sowie eine dieser gegenüberliegende Kaltseite 17 auf. Im Wärmetauscher 7 sind mehrere Heizkanäle 18 zum Führen des Heizmittels ausgebildet, die an den Heißseiten 16 der thermoelektrischen Elemente 15 angeordnet sind. Ferner sind im Wärmetauscher 7 mehrere Kühlkanäle 19 vorgesehen, die das Kühlmittel führen und die an den Kaltseiten 17 der thermoelektrischen Elemente 15 angeordnet sind. Die thermoelektrischen Generatoren 13, die Heizkanäle 18 und die Kühlkanäle 19 sind in einer durch einen Doppelpfeil angedeuteten Stapelrichtung 20 einander abwechselnd benachbart angeordnet und bilden dabei einen Kanalstapel 21, der in einem vom Gehäuse 8 umhüllten Innenraum 22 aufgenommen ist. Für sämtliche Heizkanäle 18 besitzt das Gehäuse 8 einen gemeinsamen Heizmitteleinlass 11 und einen gemeinsamen Heizmittelauslass 12. Für sämtliche Kühlmittelkanäle 19 besitzt das Gehäuse 8 einen gemeinsamen Kühlmitteleinlass 9 und einen gemeinsamen Kühlmittelauslass 10.

Im Innenraum 22 des Gehäuses 8 sind in den hier gezeigten Beispielen jeweils vier doppelwandige Zwischenböden 23 untergebracht, wobei in jedem Zwischenboden 23 ein solcher thermoelektrischer Generator 13 mit seinen zugehörigen thermoelektrischen Elementen 15 angeordnet ist. Ferner ist der jeweilige Zwischenboden 23 im Gehäuse 8 so angeordnet, dass er jeweils einen solchen Kühlkanal 19 von einem solchen Heizkanal 18 fluidisch trennt.

Im Einzelnen kann der jeweilige Zwischenboden 23 jeweils eine Heißwand 24 und jeweils eine Kühlwand 25 sowie einen Zwischenraum 26 aufweisen, der jeweils zwischen der zugehörigen Heißwand 24 und der zugehörigen Kaltwand 25 ausgebildet ist. Die jeweilige Heißwand 24 begrenzt einen Heizkanal 18 und trennt somit den Zwischenraum 26 vom Heizmittel des Heizkanals 18. Die jeweilige Kühlwand 25 begrenzt einen solchen Kühlkanal 19 und trennt den Zwischenraum 26 vom Kühlmittel des jeweiligen Kühlkanals 19. Im jeweiligen Zwischenraum 26 sind nun die thermoelektrischen Elemente 15 des jeweiligen thermoelektrischen Generators 13 angeordnet, und zwar zweckmäßig derart, dass die Heißseiten 16 der thermoelektrischen Elemente 15 direkt oder indirekt an der jeweiligen Heizwand 24 anliegen, während die Kaltseiten 17 der thermoelektrischen Elemente 15 direkt oder indirekt an der jeweiligen Kühlwand 25 anliegen.

Beim jeweiligen Zwischenboden 23 können die Heißwand 24 und die Kaltwand 25 durch separate, insbesondere ebene, Wandelemente oder Platten gebildet sein, die auf geeignete Weise in das Gehäuse 8 eingesetzt sind. Besonders vorteilhaft ist dagegen eine Ausführungsform, bei der der jeweilige Zwischenboden 23 durch ein Flachrohr gebildet ist, dessen breite Seiten die Heißwand 24 und die Kühlwand 25 bilden und dessen kurze Seiten jeweils an einer Seitenwand des Gehäuses 8 anliegen.

Zweckmäßig können die thermoelektrischen Elemente 15 im Zwischenboden 23 individuell ungekapselt angeordnet sein. Das bedeutet, dass beim jeweiligen thermoelektrischen Element 15 ein thermoelektrischer Körper, der die Heißseite 16 und die Kaltseite 17 aufweist und aus einem thermoelektrischen Material besteht, direkt oder indirekt an der Heizwand 24 bzw. an der Kühlwand 25 anliegt. Die Anordnung des jeweiligen Zwischenbodens 23 im Gehäuse 8 kann dagegen zweckmäßig so erfolgen, dass dadurch die thermoelektrischen Elemente 15 des jeweiligen thermoelektrischen Generators 13 im jeweiligen Zwischenboden 23 als Gruppe gekapselt sind.

Bei den in den Figuren 2 und 3 gezeigten Ausführungsformen sind sämtliche Heizkanäle 18 über Heizmittel-Verbindungsrohre 27 miteinander fluidisch verbunden, wobei sich diese Heizmittel-Verbindungsrohre 27 jeweils durch wenigstens einen Kühlkanal 19 und durch wenigstens einen Zwischenboden 23 durchgeführt sind. Ferner sind hier sämtliche Kühlkanäle 19 über Kühlmittel-Verbindungsrohre 28 miteinander fluidisch verbunden, wobei sich die Kühlmittel-Verbindungsrohre 28 jeweils durch wenigstens einen Heizkanal 18 sowie durch wenigstens einen Zwischenboden 23 hindurcherstrecken.

Bei der in Fig. 2 gezeigten Ausführungsform sind sowohl die Heizmittel-Verbindungsrohre 27 als auch die Kühlmittel-Verbindungsrohre 28 vom Gehäuse 8 beabstandet im Innenraum 22 angeordnet. Im Unterschied dazu zeigt Fig. 3 eine Ausführungsform, bei der nur die Heizmittel-Verbindungsrohre 27 vom Gehäuse 8 beabstandet im Innenraum 22 angeordnet sind, während die Kühlmittel-Verbindungsrohre 28 an Stirnseiten 29 des Gehäuses 8 mit Hilfe von Trennwänden 30 in Form von Kanälen realisiert sind. Diese Trennwände 30 sind dabei von der jeweiligen Stirnseite 29 des Gehäuses 8 beabstandet im Innenraum 22 angeordnet, so dass ein zwischen der jeweiligen Trennwand 30 und einem der jeweiligen Stirnseite 29 zugeordneten Gehäuseabschnitt ausgebildeter Zwischenraum einen Kühlmittel-Verbindungskanal bildet, der im Folgenden ebenfalls mit 28 bezeichnet wird.

Bei der in Fig. 3 gezeigten Ausführungsform sind bezüglich der Stapelrichtung 20 innerhalb des Kanalstapels 21 der erste oder unterste Kanal und der letzte oder oberste Kanal vom gleichen Typ, nämlich vom Typ Kühlkanal 19. Die mit Hilfe der Trennwände 30 geschaffenen Verbindungskanäle 28 verbinden nun den ersten und letzten Kühlkanal 19 sowie den hier dazwischen angeordneten mittleren Kühlkanal 19 miteinander. Bezüglich einer Umfangsrichtung, die sich auf eine senkrecht auf der Zeichnungsebene der Fig. 3 stehende, quer zur Längsrichtung des Kanalstapels 21 und quer zur Stapelrichtung 20 erstreckende Querrichtung bezieht, ist der Kanalstapel 21 im Gehäuse 8 von den Verbindungskanälen 28 und dem ersten Kühlkanal 19 sowie dem letzten Kühlkanal 19 geschlossen eingefasst. Der Kanalstapel 21 umfasst in diesem Fall den untersten oder ersten Zwischenboden 23, den letzten oder obersten Zwischenboden 23 sowie sämtliche dazwischenliegenden Zwischenböden 23, Kühlkanäle 19 und Heizkanäle 18.

Zusätzlich oder alternativ können die Verbindungskanäle 28 den Kanalstapel 21 in einer Umfangsrichtung geschlossen einfassen, die sich auf die Stapelrichtung 20 bezieht. In diesem Fall sind weitere Trennwände 30 vorgesehen, die von Längsseiten des Gehäuses 8 beabstandet sind, die sich zwischen den Stirnseiten 29 und zwischen einer Unterseite 31 und einer Oberseite 32 erstrecken. Mit Hilfe dieser Trennwände 30 können weitere Verbindungskanäle 28 entlang dieser Seitenwände geschaffen werden, die sich in Fig. 3 sowohl an einer dem Betrachter zugewandten als auch an einer vom Betrachter abgewandten Seite des Gehäuses 8 befinden. In diesem Fall ist der Kanalstapel 21, soweit er sich zwischen dem untersten und dem obersten Zwischenboden 23 erstreckt, allseits vom Kühlmittel umgeben.

Bei einer vorteilhaften Ausführungsform kann vorgesehen sein, dass der jeweilige Zwischenraum 26 der Zwischenböden 23 mit einem Inertgas gefüllt ist oder ein Vakuum enthält. In diesem Fall sind die Zwischenräume 23 zweckmäßig sowohl gegenüber dem Kühlmittel als auch gegenüber dem Heizmittel abgedichtet.

Gemäß den Figuren 2 und 3 können elektrische Leitungen 33 zur Realisierung des jeweiligen elektrischen Anschlusses 14 mit Hilfe einer geeigneten, fluiddichten Durchführung 34 vom jeweiligen Zwischenraum 26 durch das Gehäuse 8 hindurchgeführt sein.

Gemäß Fig. 4 ist es entsprechend einer anderen vorteilhaften Ausführungsform möglich, die Wände 24, 25 der Zwischenböden 23 hinsichtlich ihrer Form so an die thermoelektrischen Elemente 15 anzupassen, dass sie an die Außenkontur der thermoelektrischen Elemente 15 angepasst sind. Insbesondere kann dabei ein Abstand 35 zwischen der Heißwand 24 und der Kaltwand 25 im Bereich eines solchen thermoelektrischen Elements 15 größer sein als ein Abstand 36, den die beiden Wände 24, 25 in einem Bereich 37 aufweisen, der zwischen benachbarten thermoelektrischen Elementen 15 liegt und durch den eine elektrische Kontaktierung mittels entsprechender Leitungen 33 der benachbarten thermoelektrischen Elemente 15 erfolgt. Insbesondere können die Wände 24, 25 im Bereich der thermoelektrischen Elemente 15 vergleichsweise dünn sein, so dass sie im Wesentlichen nur eine Dichtungsfunktion erfüllen, während sie im Bereich 37 zwischen benachbarten thermoelektrischen Elementen 15 eine erhöhte Stabilität besitzen können, um die Druckdifferenzen zwischen den Kanälen 18, 19 und dem Zwischenraum 26 abstützen zu können. Alternativ kann es vorgesehen sein, den Zwischenraum 26 im Zwischenbereich 37 mittels einer geeigneten Vergussmasse 38 auszufüllen, so dass auch in diesem Zwischenbereich 37 reduzierte Wandstärken für die Wände 24, 25 möglich sind. Alternativ können die Wände 24, 25 im jeweiligen ausgegossenen Zwischenbereich 37 entfallen.

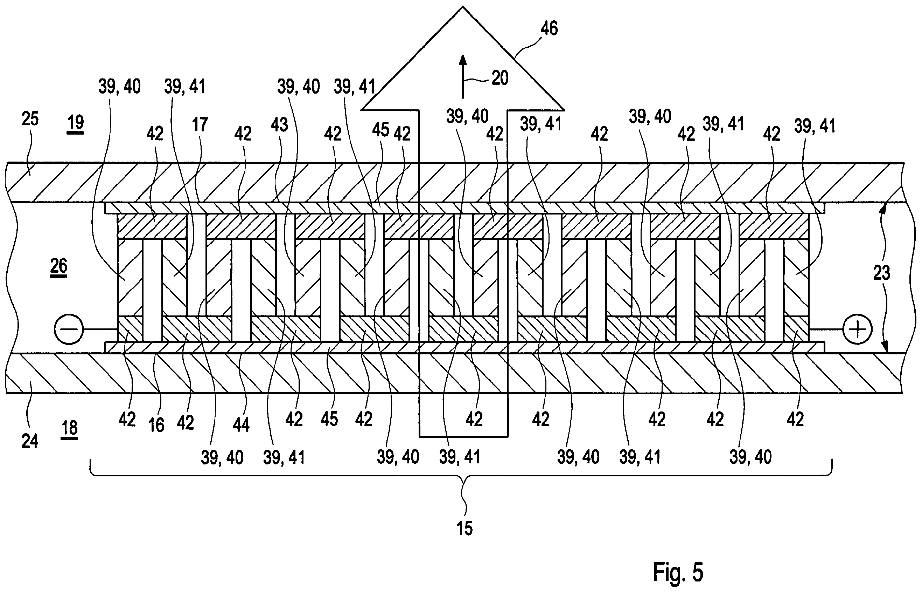

In Fig. 5 ist rein exemplarisch ein typischer Aufbau eines einzelnen thermoelektrischen Elements 15 dargestellt, das gemäß einer bevorzugten Ausführungsform des hier vorgestellten erfindungsgemäßen Wärmetauschers 7 ungekapselt ist. Das thermoelektrische Element 15 weist eine Vielzahl einzelner thermoelektrischer Halbleiterelemente 39 auf, die in bevorzugt in einer Ebene in mehreren Zeilen und Spalten angeordnet sind. In Fig. 5 ist nur eine Zeile erkennbar, an die sich zur Ausbildung der Spalten mehreren Zeilen in der Tiefenrichtung der Fig. 5 anschließen. Die Halbleiterelemente 39 sind unterschiedlich dotiert, so dass negativ dotierte n-Leiter 40 und positiv dotierte p-Leiter 41 vorgesehen sind, die sich abwechseln. Je zwei benachbarte Leiter 40, 41 sind über eine Kontaktbrücke 42, insbesondere eine Metallbrücke, elektrisch miteinander verbunden. Die Kontaktbrücken erstrecken sich dabei an einer Oberseite 43 des elektrothermischen Elements 15, die hier durch die Kaltseite 17 gebildet ist, und an einer Unterseite 44 des elektrothermischen Elements 15, die hier durch die Heißseite 16 gebildet ist, jeweils in einer Ebene und sind jeweils von einem elektrischen Isolator 45 abgedeckt. Über diesen Isolator 45 steht das jeweilige elektrothermische Element 15 mit der Heißwand 24 bzw. mit der Kaltwand 25 in Kontakt. Ein Pfeil 46 deutet den Wärmestrom durch das jeweilige thermoelektrische Element 15 an.

## Patentansprüche

1. Wärmetauscher, insbesondere für eine Abgasanlage (5) einer Brennkraftmaschine (1), vorzugsweise in einem Kraftfahrzeug,
- mit mindestens einem thermoelektrischen Generator (13), der mehrere thermoelektrische Elemente (15) umfasst, die jeweils eine Heißseite (16) und eine Kaltseite (17) aufweisen,
- mit mindestens einem Heizkanal (18) zum Führen eines Heizmittels, der an den Heißseiten (16) der thermoelektrischen Elemente (15) wenigstens eines solchen thermoelektrischen Generators (13) angeordnet ist,
- mit mindestens einem Kühlkanal (19) zum Führen eines Kühlmittels, der an den Kaltseiten (17) der thermoelektrischen Elemente (15) wenigstens eines solchen thermoelektrischen Generators (13) angeordnet ist,
- wobei der wenigstens eine thermoelektrische Generator (13), der wenigstens eine Heizkanal (18) und der wenigstens eine Kühlkanal (19) in einer Stapelrichtung (20) benachbart angeordnet sind und einen Kanalstapel (21) bilden,
- mit einem Gehäuse (8), das einen den Kanalstapel (21) aufnehmenden Innenraum (22) umhüllt, das einen Kühlmitteleinlass (9), einen Kühlmittelauslass (10), einen Heizmitteleinlass (11) und einen Heizmittelauslass (12) sowie elektrische Anschlüsse (14) für den jeweiligen thermoelektrischen Generator (13) aufweist,
- wobei im Innenraum (22) des Gehäuses (8) wenigstens ein doppelwandiger Zwischenboden (23) angeordnet ist, in dem die thermoelektrischen Elemente (15) eines solchen thermoelektrischen Generators (13) angeordnet sind und der einen solchen Kühlkanal (19) von einem solchen, dazu benachbarten Heizkanal (18) fluidisch trennt,
**dadurch gekennzeichnet,**
- **dass** wenigstens zwei solche Heizkanäle (18) über Heizmittel-Verbindungsrohre (27) miteinander fluidisch verbunden sind, die sich durch einen Kühlkanal (19) und durch wenigstens einen Zwischenboden (23) hindurcherstrecken, wobei sich die Heizmittel-Verbindungsrohre (27) beabstandet vom Gehäuse (8) im Innenraum (22) erstrecken und im jeweiligen Kühlkanal (19) dem Kühlmittel ausgesetzt sind, und/oder
- **dass** wenigstens zwei solche Kühlmittelkanäle (19) über Kühlmittel-Verbindungsrohre (28) miteinander fluidisch verbunden sind, die sich durch einen Heizkanal (18) und durch wenigstens einen Zwischenboden (23) hindurcherstrecken, wobei sich die Kühlmittel-Verbindungsrohre (28) beabstandet vom Gehäuse (8) im Innenraum (22) erstrecken und im jeweiligen Heizkanal (18) dem Heizmittel ausgesetzt sind.

2. Wärmetauscher nach Anspruch 1,
**dadurch gekennzeichnet,**
**dass** das jeweilige thermoelektrische Element (15) mehrere thermoelektrische Halbleiterelemente aufweist, die insbesondere als p-Leiter und n-Leiter ausgestaltet sind.

3. Wärmetauscher nach Anspruch 1 oder 2,
**dadurch gekennzeichnet,**
- **dass** der jeweilige Zwischenboden (23) eine Heißwand (24), eine Kühlwand (25) und einen zwischen Heißwand (24) und Kühlwand (25) ausgebildeten Zwischenraum (26) aufweist,
- **dass** die jeweilige Heißwand (24) einen solchen Heizkanal (18) begrenzt und den Zwischenraum (26) vom Heizmittel dieses Heizkanals (18) trennt,
- **dass** die jeweilige Kühlwand (25) einen solchen Kühlkanal (19) begrenzt und den Zwischenraum (26) vom Kühlmittel dieses Kühlkanals (19) trennt,
- **dass** im jeweiligen Zwischenraum (26) die thermoelektrischen Elemente (15) eines solchen thermoelektrischen Generators (13) angeordnet sind, so dass die Heißseiten (16) der thermoelektrischen Elemente (15) direkt oder indirekt an der Heizwand (24) anliegen und die Kaltseiten (17) der thermoelektrischen Elemente (15) direkt oder indirekt an der Kühlwand (25) anliegen.

4. Wärmetauscher nach einem der Ansprüche 1 bis 3,
**dadurch gekennzeichnet,**
**dass** die thermoelektrischen Elemente (15) des jeweiligen thermoelektrischen Generators (13) im jeweiligen Zwischenboden (23) individuell ungekapselt sind und durch den Zwischenboden (23) als Gruppe gekapselt sind.

5. Wärmetauscher nach einem der Ansprüche 1 bis 4, sofern nur die erste Variante gemäß dem Kennzeichen des Anspruchs 1 vorliegt,
**dadurch gekennzeichnet,**
- **dass** im Kanalstapel (21) bezüglich der Stapelrichtung (20) der erste Kanal und der letzte Kanal vom gleichen Typ, also Heizkanäle (18) oder Kühlkanäle (19) sind,
- **dass** der Kanalstapel (21) zwischen dem in der Stapelrichtung (20) ersten und letzten Zwischenboden (23) im Gehäuse (8) quer zur Stapelrichtung (20) in einer Umfangsrichtung geschlossen von Verbindungskanälen (28) eingefasst ist, welche den ersten Kanal und den letzten Kanal sowie jeden weiteren gegebenenfalls vorhandenen Kanal des gleichen Typs fluidisch miteinander verbinden.

6. Wärmetauscher nach Anspruch 5,
**dadurch gekennzeichnet,**
**dass** sich die Umfangsrichtung auf die Stapelrichtung (20) oder auf eine quer zur Stapelrichtung (20) und quer zur Längsrichtung des Kanalstapels (21) verlaufende Querrichtung bezieht.

7. Wärmetauscher nach Anspruch 5 oder 6,
**dadurch gekennzeichnet,**
**dass** der erste Kanal und der letzte Kanal Kühlkanäle (19) sind.

8. Wärmetauscher nach einem der Ansprüche 3 bis 7,
**dadurch gekennzeichnet,**
**dass** der jeweilige Zwischenraum (26) sowohl gegenüber dem Kühlmittel als auch gegenüber dem Heizmittel abgedichtet ist.

9. Wärmetauscher nach einem der Ansprüche 3 bis 8,
**dadurch gekennzeichnet,**
**dass** der jeweilige Zwischenraum (26) mit einem Inertgas gefüllt ist oder ein Vakuum enthält.

10. Wärmetauscher nach einem der Ansprüche 1 bis 9,
**dadurch gekennzeichnet,**
**dass** der jeweilige Zwischenboden (23) durch zwei im Gehäuse (8) angeordnete und in der Stapelrichtung (20) voneinander beabstandete separate Wände (24, 25) gebildet ist.

11. Wärmetauscher nach einem der Ansprüche 1 bis 9,
**dadurch gekennzeichnet,**
**dass** der jeweilige Zwischenboden (23) durch ein in das Gehäuse (8) eingesetztes Flachrohr gebildet ist.

12. Brennkraftmaschine, insbesondere für ein Kraftfahrzeug,
- mit einem Motorblock (2), der mehrere Brennräume (3) enthält,
- mit einer Abgasanlage (5) zum Abführen von Abgas von den Brennräumen (3),
- mit einem Kühlkreis (6) zum Kühlen des Motorblocks (2),
- mit einem Wärmetauscher (7) nach einem der Ansprüche 1 bis 11, dessen Heizkanäle (18) mit der Abgasanlage (5) fluidisch gekoppelt sind und dessen Kühlkanäle (19) mit dem Kühlkreis (6) fluidisch gekoppelt sind.

## Claims

1. A heat exchanger, in particular for an exhaust system (5) of an internal combustion engine (1), preferentially in a motor vehicle,
- with at least one thermoelectric generator (13), which comprises multiple thermoelectric elements (15), each of which have a hot side (16) and a cold side (17),
- with at least one heating channel (18) for conducting a heating medium, which is arranged on the hot sides (16) of the thermoelectric elements (15) of at least one such thermoelectric generator (13),
- with at least one cooling channel (19) for conducting a cooling medium, which is arranged on the cold sides (17) of the thermoelectric elements (15) of at least one such thermoelectric generator (13),
- wherein the at least one thermoelectric generator (13), the at least one heating channel (18) and the at least one cooling channel (19) are arranged adjacent in a stacking direction (20) and form a channel stack (21),
- with a housing (8), which covers an interior space (22) receiving the channel stack (21), which comprises a cooling medium inlet (9), a cooling medium outlet (10), a heating medium inlet (11) and a heating medium outlet (12) as well as electrical connections (14) for the respective thermoelectric generator (13),
- wherein in the interior space (22) of the housing (8) at least one double-walled intermediate bottom (23) is arranged, in which the thermoelectric elements (15) of such a thermoelectric generator (13) are arranged and which fluidically separates such a cooling channel (19) from such a heating channel (18) which is adjacent thereto,
**characterized**
- **in that** at least two such heating channels (18) are fluidically connected to one another via heating medium connecting tubes (27), which extend through a cooling channel (19) and through at least one intermediate bottom (23), wherein the heating medium connecting tubes (27) extend spaced from the housing (8) in the interior space (22) and are exposed to the cooling medium within the respective cooling channel (19), and/or
- **in that** at least two such cooling medium channels (19) are fluidically connected to one another via cooling medium connecting tubes (28), which extend through a heating channel (18) and through at least one intermediate bottom (23), wherein the cooling medium connecting tubes (28) extend spaced from the housing (8) in the interior space (22) and are exposed to the heating medium within the respective heating channel (18).

2. The heat exchanger according to Claim 1,
**characterized**
**in that** the respective thermoelectric element (15) comprises multiple thermoelectric semiconductor elements, which are configured in particular as p-conductors and n-conductors.

3. The heat exchanger according to Claim 1 or 2, **characterized**
- **in that** the respective intermediate bottom (23) comprises a hot wall (24), a cooling wall (25) and an intermediate space (26) formed between hot wall (24) and cooling wall (25),
- **in that** the respective hot wall (24) bounds such a heating channel (18) and separates the intermediate space (26) from the heating means of this heating channel (18),
- **in that** the respective cooling wall (25) bounds such a cooling channel (19) and separates the intermediate space (26) from the cooling medium of this cooling channel (19),
- **in that** in the respective intermediate space (26) the thermoelectric elements (15) of such a thermoelectric generator (13) are arranged, so that the hot sides (16) of the thermoelectric elements (15) directly or indirectly contact the heating wall (24) and the cold sides (17) of the thermoelectric elements (15) directly or indirectly contact the cooling wall (25).

4. The heat exchanger according to any one of the Claims 1 to 3,
**characterized**
**in that** the thermoelectric elements (15) of the respective thermoelectric generator (13) in the respective intermediate bottom (23) are individually unencapsulated and are encapsulated as a group through the intermediate bottom (23).

5. The heat exchanger according to any one of the Claims 1 to 4, if only the first variant according to the characterizing part of claim 1 is present, **characterized**
- **in that** in the channel stack (21) with respect to the stacking (20) the first channel and the last channel are of the same type, i.e. heating channels (18) or cooling channels (19),
- **in that** the channel stack (21) in the stacking direction (20) first and last intermediate bottom (23) in the housing (8) is enclosed transversely to the stacking direction (20) closed in a circumferential direction by connecting channels (28), which fluidically connect the first channel and the last channel as well as each further channel of the same type that may be present with one another.

6. The heat exchanger according to Claim 5,
**characterized**
**in that** the circumferential direction relates to the stacking direction (20) or to a transverse direction running transversely to the stacking direction (20) and transversely to the longitudinal direction of the channel stack (21).

7. The heat exchanger according to Claim 5 or 6,
**characterized**
**in that** the first channel and the last channel are cooling channels (19).

8. The heat exchanger according to any one of the Claims 3 to 7,
**characterized**
**in that** the respective intermediate space (26) is sealed both with respect to the cooling medium and also with respect to the heating medium.

9. The heat exchanger according to any one of the Claims 3 to 8,
**characterized**
**in that** the respective intermediate space (26) is filled with an inert gas or contains a vacuum.

10. The heat exchanger according to any one of the Claims 1 to 9,
**characterized**
**in that** the respective intermediate bottom (23) is formed by two separate walls (24, 25) which are arranged in the housing (8) and in the stacking direction (20) are spaced from one another.

11. The heat exchanger according to any one of the Claims 1 to 9,
**characterized**
**in that** the respective intermediate bottom (23) is formed by a flat tube inserted in the housing (8).

12. An internal combustion engine, in particular for a motor vehicle,
- with an engine block (2), containing multiple combustion chambers (3),
- with an exhaust system (5) for discharging exhaust gas from the combustion chambers (3),
- with a cooling circuit (6) for cooling the engine block (2),
- with a heat exchanger (7) according to any one of the Claims 1 to 11, the heating channels (18) of which are fluidically coupled to the exhaust system (5) and the cooling channels (19) of which are fluidically coupled to the cooling circuit (6).

## Revendications

1. Echangeur de chaleur, en particulier pour une installation d'échappement (5) d'un moteur à combustion interne (1), de préférence dans un véhicule automobile,
- avec au moins un générateur thermoélectrique (13) qui comporte plusieurs éléments thermoélectriques (15) qui présentent respectivement un côté chaud (16) et un côté froid (17),
- avec au moins un canal de chauffage (18) pour acheminer un moyen de chauffage qui est agencé sur les côtés chauds (16) des éléments thermoélectriques (15) au moins d'un tel générateur thermoélectrique (13),
- avec au moins un canal de refroidissement (19) pour acheminer un moyen de refroidissement qui est agencé sur les côtés froids (17) des éléments thermoélectriques (15) au moins d'un tel générateur thermoélectrique (13),
- dans lequel l'au moins un générateur thermoélectrique (13), l'au moins un canal de chauffage (18) et l'au moins un canal de refroidissement (19) sont agencés dans un sens d'empilement (20) de manière contiguë et forment une pile de canal (21),
- avec un boîtier (8) qui entoure un espace intérieur (22) recevant la pile de canal (21), qui présente une entrée de moyen de refroidissement (9), une sortie de moyen de refroidissement (10), une entrée de moyen de chauffage (11) et une sortie de moyen de chauffage (12) ainsi que des raccords électriques (14) pour le générateur thermoélectrique (13) respectif,
- dans lequel dans l'espace intérieur (22) du boîtier (8) au moins un fond intermédiaire à double paroi (23) est agencé, dans lequel les éléments thermoélectriques (15) d'un tel générateur thermoélectrique (13) sont agencés et
qui sépare fluidiquement un tel canal de refroidissement (19) d'un tel canal de chauffage (18) contigu à celui-ci,
**caractérisé en ce**
- **qu'**au moins deux tels canaux de chauffage (18) sont reliés fluidiquement entre eux par des tubes de liaison de moyen de chauffage (27) qui s'étendent au travers d'un canal de refroidissement (19) et au travers d'au moins un fond intermédiaire (23), dans lequel les tubes de liaison de moyen de chauffage (27) s'étendent à distance du boîtier (8) dans l'espace intermédiaire (22) et sont exposés dans le canal de refroidissement (19) respectif au moyen de refroidissement, et/ou
- **qu'**au moins deux tels canaux de moyen de refroidissement (19) sont reliés fluidiquement entre eux par des tubes de liaison de moyen de refroidissement (28) qui s'étendent au travers d'un canal de chauffage (18) et au travers d'au moins un fond intermédiaire (23), dans lequel les tubes de liaison de moyen de refroidissement (28) s'étendent à distance du boîtier (8) dans l'espace intérieur (22) et sont exposés dans le canal de chauffage (18) respectif au moyen de chauffage.

2. Echangeur de chaleur selon la revendication 1,
**caractérisé en ce**
**que** l'élément thermoélectrique (15) respectif présente plusieurs éléments à semi-conducteur thermoélectriques qui sont configurés en particulier comme conducteur p et conducteur n.

3. Echangeur de chaleur selon la revendication 1 ou 2,
**caractérisé en ce**
- **que** le fond intermédiaire (23) respectif présente une paroi chaude (24), une paroi de refroidissement (25) et un espace intermédiaire (26) réalisé entre la paroi chaude (24) et la paroi de refroidissement (25),
- **que** la paroi chaude (24) respective délimite un tel canal de chauffage (18) et sépare l'espace intermédiaire (26) du moyen de chauffage de ce canal de chauffage (18),
- **que** la paroi de refroidissement (25) respective délimite un tel canal de refroidissement (19) et sépare l'espace intermédiaire (26) du moyen de refroidissement de ce canal de refroidissement (19),
- **que** dans l'espace intermédiaire (26) respectif les éléments thermoélectriques (15) d'un tel générateur thermoélectrique (13) sont agencés de sorte que les côtés chauds (16) des éléments thermoélectriques (15) reposent directement ou indirectement contre la paroi de chauffage (24) et les côtés froids (17) des éléments thermoélectriques (15) reposent directement ou indirectement contre la paroi de refroidissement (25).

4. Echangeur de chaleur selon l'une quelconque des revendications 1 à 3,
**caractérisé en ce**
**que** les éléments thermoélectriques (15) du générateur thermoélectrique (13) respectif sont décapsulés individuellement dans le fond intermédiaire (23) respectif et sont capsulés par le fond intermédiaire (23) comme groupe.

5. Echangeur de chaleur selon l'une quelconque des revendications 1 à 4, dans la mesure où seule la première variante selon la caractéristique de la revendication 1 se présente,
**caractérisé en ce**
- **que** dans la pile de canal (21) par rapport au sens d'empilement (20) le premier canal et le dernier canal sont du même type, donc des canaux de chauffage (18) ou canaux de refroidissement (19),
- **que** la pile de canal (21) est entourée fermée entre le premier et le dernier fond intermédiaire (23) dans le sens d'empilement (20) dans le boîtier (8) transversalement au sens d'empilement (20) dans un sens périphérique par des canaux de liaison (28) qui relient entre eux fluidiquement le premier canal et le dernier canal ainsi que chaque autre canal présent éventuellement du même type.

6. Echangeur de chaleur selon la revendication 5,
**caractérisé en ce**
**que** le sens périphérique se réfère au sens d'empilement (20) ou à un sens transversal s'étendant transversalement au sens d'empilement (20) et transversalement au sens longitudinal de la pile de canal (21).

7. Echangeur de chaleur selon la revendication 5 ou 6,
**caractérisé en ce**
**que** le premier canal et le dernier canal sont des canaux de refroidissement (19).

8. Echangeur de chaleur selon l'une quelconque des revendications 3 à 7,
**caractérisé en ce**
**que** l'espace intermédiaire (26) respectif est rendu étanche non seulement par rapport au moyen de refroidissement mais aussi par rapport au moyen de chauffage.

9. Echangeur de chaleur selon l'une quelconque des revendications 3 à 8,
**caractérisé en ce**
**que** l'espace intermédiaire (26) respectif est rempli d'un gaz inerte ou contient un vide.

10. Echangeur de chaleur selon l'une quelconque des revendications 1 à 9,
**caractérisé en ce**
**que** le fond intermédiaire (23) respectif est formé par deux parois séparées (24, 25) agencées dans le boîtier (8) et espacées dans le sens d'empilement (20) l'une de l'autre.

11. Echangeur de chaleur selon l'une quelconque des revendications 1 à 9,
**caractérisé en ce**
**que** le fond intermédiaire (23) respectif est formé par un tube plat inséré dans le boîtier (8).

12. Moteur à combustion interne, en particulier pour un véhicule automobile,
- avec un bloc moteur (2) qui contient plusieurs espaces de combustion (3),
- avec une installation d'échappement (5) pour l'évacuation de gaz d'échappement des espaces de combustion (3),
- avec un circuit de refroidissement (6) pour le refroidissement du bloc moteur (2),
- avec un échangeur de chaleur (7) selon l'une quelconque des revendications 1 à 11, dont les canaux de chauffage (18) sont couplés fluidiquement à l'installation d'échappement (5) et dont les canaux de refroidissement (19) sont couplés fluidiquement au circuit de refroidissement (6).
